# EUROPEAN PATENT SPECIFICATION

(11) **EP 1 457 833 B1**
(45) Date of publication and mention of the grant of the patent: **30.05.2012**
(21) Application number: 04251312.7
(22) Date of filing: 05.03.2004
(51) Int. Cl.: G03F 7/20

(54) **Lithographic apparatus, device manufacturing method, and device manufactured thereby**
Lithographischer Apparat, Verfahren zur Herstellung eines Artikels und damit erzeugter Artikel
Appareil lithographique, procédé pour la production d'un dispositif et dispositif produit par ce procédé

(30) Priority: 11.03.2003 EP 03251456
(43) Date of publication of application: 15.09.2004
(73) Proprietor: ASML Netherlands B.V., 5504 DR Veldhoven (NL)
(72) Inventor: Vreugdewater, Patricia, 5658 BC Eindhoven (NL); Hol, Sven Antoin Johan, 5623 AW Eindhoven (NL); Cox, Henrikus Herman Marie, 5646 JH Eindhoven (NL)

(56) References cited:
- EP-A- 1 124 160
- US-A- 6 005 310
- US-A1- 2002 096 946
- US-B1- 6 184 596

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a Lorentz actuator, comprising a coil arrangement in thermal contact with at least one cooling element.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface.
   The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ―commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

A commonly used actuator in this field is the Lorentz actuator. In such a device, an actuating force is derived from the magnetic field associated with a current driven through a suitably arranged coil. It is generally desirable that actuators of this type are as compact and powerful as possible. To increase the power and/or increase the size of a Lorentz actuator, it is necessary to increase the current density in the coils. However, increased current density leads to increased heat dissipation which is undesirable as high operating temperatures reduce component lifetimes and may disturb adjacent heat sensitive components.

Known designs of Lorentz actuator are cooled by cooling plates, through which water is circulated, attached to the coils. Simply increasing the flow of coolant still leaves undesirable variations in temperature in the body of the coil.

US 6 184 596 B1 discloses a magnetically levitated movable stage for use in a semiconductor exposure device. According to an embodiment, a plurality of electromagnets are housed in a closed plenum of a fixed stage. Inlet and outlet apertures for cooling water are formed in further plenums positioned above and below the plane of the electromagnets so as to supply a flow of cooling water. Further, the surfaces of the electromagnets are covered with a layer of a resin which has excellent heat conducting properties, i.e. which has a high coefficient of thermal conductivity.

EP 1 124 160 A2 discloses a voice coil motor for use in a positioning means for an object table in a lithographic projection apparatus, in which the coil is cooled by a cooling jacket in thermal contact with the coil. The cooling jacket comprises at least one channel for circulation of a cooling fluid, each channel being arranged such as to be substantially located in a portion of the cooling jacket adjacent to the coil.

US 2002/0096946 A1 discloses a coil comprising current-conducting turns and cooling means for cooling the coil. To improve the cooling efficiency, the coil comprises a plurality of heat conducting foil turns. These foil turns can be thermally connected to a cooling channel with a cooling fluid in a preferred embodiment. The heat-conducting foil turns can be the current conducting turns.

US 6,005,310 A discloses a brushless, linear motor in which the armature coils are cast in a resin to form an armature plate. The armature coils may be wound on a laminated, magnetic structure such as steel laminates. The coils may be encapsulated with a thermally conductive compound. The encapsulating compound can be in intimate thermal contact with the coils and a carriage structure comprising a back iron plate and a heat sink.

It is an object of the present invention to provide a Lorentz actuator having improved thermal behaviour.

The scope of the invention is defined in the appended claims.

By employing a plurality of coils rather than a single coil, the average coil cross-section is reduced. The hotspot temperature depends on the rate at which heat is conducted away from the coils into the separation layers and cooling element. Splitting a parent coil into smaller coils has the effect of increasing the area of contact, and reducing the spatial separation, between the coils and the separation layers/cooling element. The result is a more efficient thermal connection that conducts heat more rapidly away from the coils, thus helping to reduce hotspot temperatures.

Although the thermal behaviour of a Lorentz actuator is improved through the use of a plurality of coils, there are practical limits that govern the best number to choose. Firstly, the separation layers inserted between individual coils undesirably increase the volume of the coil arrangement. Secondly, the complexity of the required electrical connections increases with the number of coils, as does the cost of manufacture. It is found that for many purposes an optimal balance is achieved with two coils.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g*. with a wavelength of 365, 248, 193, 157 or 126 nm) and EUV (extreme ultra-violet radiation, *e.g*. having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 depicts the coil arrangement of a Lorentz actuator according to the prior art.
Figure 3 depicts a coil arrangement of a Lorentz actuator according to a preferred embodiment of the present invention.
Figure 4 depicts a coil arrangement of a Lorentz actuator not according to the present invention.
Figure 5 depicts a coil arrangement of a Lorentz actuator not according to the present invention comprising two cooling plates.
Figure 6 depicts a coil arrangement of a Lorentz actuator not according to the present invention wherein the separation layer also comprises cooling channels.
Figure 7 depicts a coil arrangement of a Lorentz actuator not according to the present invention comprising three coils separated by four cooling plates.

In the Figures, corresponding reference symbols indicate corresponding parts.

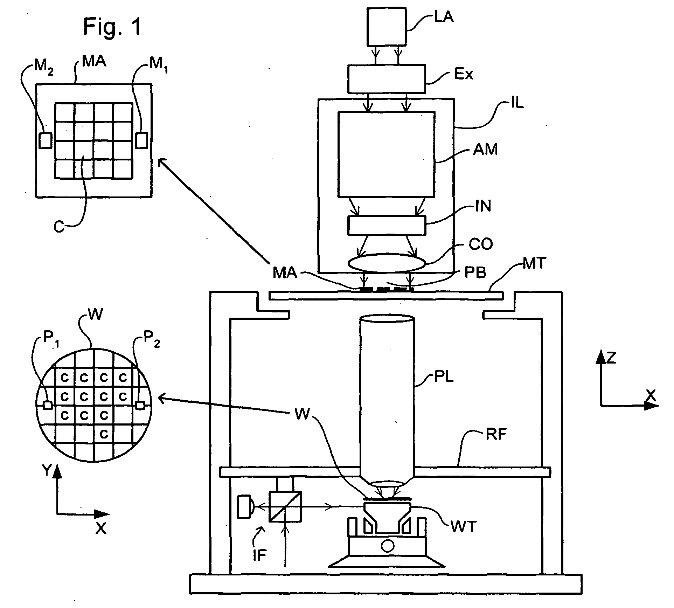

Figure 1 schematically depicts a lithographic projection apparatus according to a particular embodiment of the invention. The apparatus comprises:
. a radiation system Ex, IL, for supplying a projection beam PB of radiation (e.g. DUV radiation), which in this particular case also comprises a radiation source LA;
. a first object table (mask table) MT provided with a mask holder for holding a mask MA (*e.g.* a reticle), and connected to first positioning means for accurately positioning the mask with respect to item PL;
. a second object table (substrate table) WT provided with a substrate holder for holding a substrate W (*e.g.* a resist-coated silicon wafer), and connected to second positioning means for accurately positioning the substrate with respect to item PL;
. a projection system ("lens") PL (e.g. a refractive lens system) for imaging an irradiated portion of the mask MA onto a target portion C (*e.g.* comprising one or more dies) of the substrate W.
As here depicted, the apparatus is of a transmissive type (*e.g.* has a transmissive mask). However, in general, it may also be of a reflective type, for example (*e.g.* with a reflective mask). Alternatively, the apparatus may employ another kind of patterning means, such as a programmable mirror array of a type as referred to above.

The source LA (*e.g.* an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as (σ-outer and (σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, e.g. so as to position different target portions C in the path of the beam PB. Similarly, the first positioning means can be used to accurately position the mask MA with respect to the path of the beam PB, e.g. after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go *(i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed ν, so that the projection beam PB is caused to scan over a mask image; concurrently, the substrate table WT is simultaneously moved in the same or opposite direction at a speed *V* = *Mν,* in which *M* is the magnification of the lens PL (typically, *M* = 1/4 or 1/5). In this manner, a relatively large target portion C can be exposed, without having to compromise on resolution.

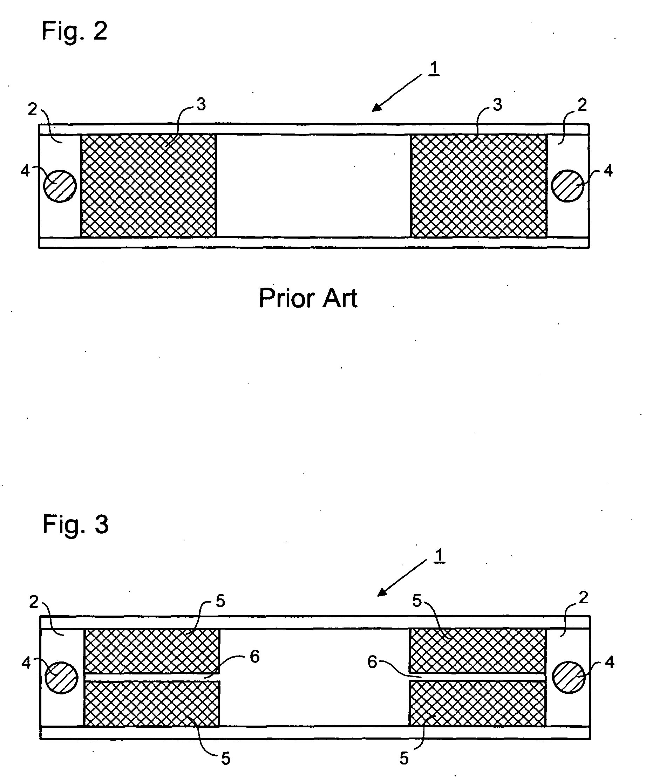

A Lorentz actuator relies on a magnetic field to apply the actuating force, which is typically produced by driving a current through a coil arrangement. Each of Figures 2, 3 and 4 are cross-sectional views of coil arrangements 1 for a Lorentz actuator, cut by a vertical plane passing through a diameter of the coil(s). Heat is inevitably generated due to the finite electrical resistance of the coils 3,5 and needs to be conducted efficiently away if the coils 3,5 are not to overheat.

Figure 2 represents a prior art coil arrangement 1. Here, a single coil 3 is provided in contact with a cooling element of high thermal conductivity. For a vertical magnetic field, a current flow in the coil 3 is directed into the page on the right of the figure and out of the page on the left of the figure. As the temperature of the coil 3 rises, heat flows out of the coil 3 into the cooling element. The cooling element, which is this example, comprises a cooling element plate 2, is cooled in turn by a network of cooling channels 4, running through the cooling element plate 2, within which a coolant, such as water, is circulated. The problem with this arrangement is that there is a relatively poor thermal contact between the center of the coil 3 and the cooling element, leading to hotspots that can damage the coil arrangement 1 over time or thermally disturb adjacent heat sensitive components.

According to one aspect of the present invention, which is illustrated in Figure 3 the situation can be greatly improved by splitting the parent coil into a number of smaller coils 5 each separated by a separation layer 6 of high thermal conductivity material, arranged to be in good thermal contact with at least one cooling element. The close proximity of the separation layer 6 to the center of each hotspot provides both a low thermal resistance pathway to the cooling element and a high temperature gradient, both of which encourage a rapid flow of heat away from the coils 5.

According to a further aspect of the present invention, it is possible to improve the thermal contact between the separation layers 6 and the cooling element by locating them in direct line with each other. When adopting a configuration such as that depicted in Figure 3, wherein two identical coils 5 are located adjacent to each other with a separation layer 6 oriented radially, it is best to locate the cooling element radially outwards from the coils 5 in line with the separation layer 6 as shown.

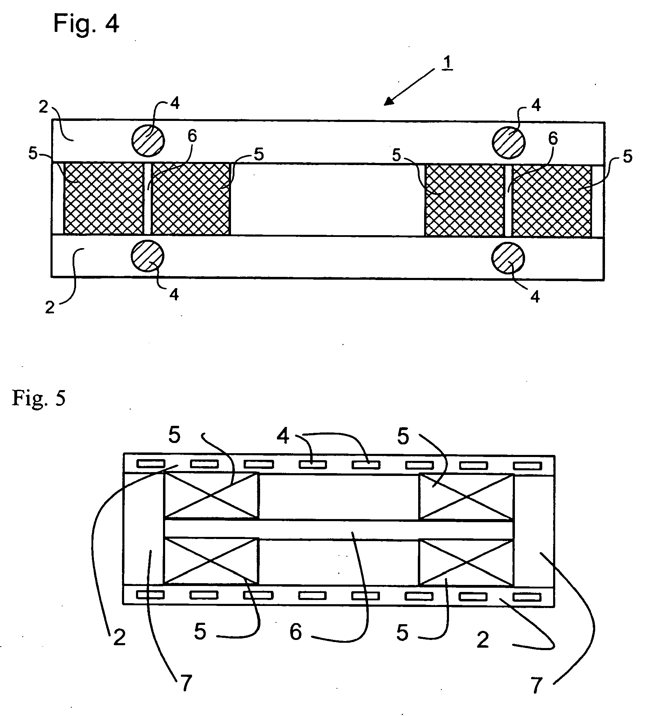

Alternatively, when adopting a configuration not according to the invention such as that depicted in Figure 4, wherein coplanar coils 3 of differing radii are located one within the other with a separation layer 6 oriented perpendicularly to the plane of the coils 5, it is more effective to locate the cooling channel above or below the coils 5 in line with the separation layer 6 as shown.

For each of the above two configurations, it is possible to vary the number of cooling channels 4 within the cooling plates 2. A larger number of cooling channels 2 will normally provide greater cooling. In any case, the cooling channels 4 normally represent the coolest portions of the cooling element and are therefore best located to be as much as possible in line with the separation layers 6. The cooling channels 4 may be substantially circular or substantially rectangular in cross-section, each having certain advantages with regard to ease of manufacture and arrangement. When adopting a combination of the above two configurations, a more complex arrangement of both cooling channels 4 and cooling element may be desirable in order to position each to be as much as possible in line with the separation layers 6.

An alternative arrangement not according to the invention is shown in figure 5 comprising a coil arrangement of two coils 5 enclosed by two cooling plates 2 provides with cooling channels 4. In between the two coils a separation layer 6 is provided. Thermal contact between the cooling plates and the separation layer is provided by the elements 7 that are made of a material with a high thermal conductivity. It should be noted that those elements may also be provided with cooling channels.

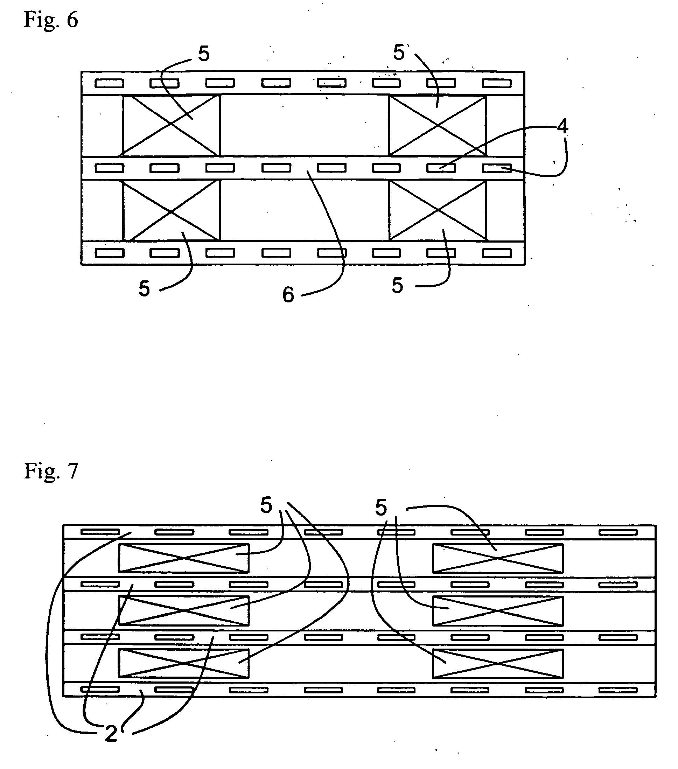

In a further embodiment not according to the invention, the separation layer 6 is also provided with cooling channels 4, as shown in figure 6. The coil arrangement shown comprises two coils 5 enclosed by two cooling plates, similar to figure 5. In such an arrangement, it may not be necessary to connect the cooling plates on the outside of the coil assembly with the inner separation layer provided with the cooling channels. The arrangement shown in figure 6 can further be expanded to coil arrangements wherein the number of coils is larger than 2. Figure 7 shows a coil arrangement not according to the invention comprising 4 cooling plates 2 enclosing three coils 5. The number of separation layers (or cooling plates) may be determined by the thermal requirements of the application, i.e. the amount of dissipation in the coils and the maximum allowable temperature of the coils.

Whilst specific embodiments of the invention have been described above, it will be appreciated that the invention may be practiced otherwise than as described. The description is not intended to limit the invention.

## Claims

1. A lithographic projection apparatus comprising:
- a radiation system (Ex,IL) for providing a projection beam (PB) of radiation;
- a support structure (MT) for supporting patterning means (MA), the patterning means (MA) serving to pattern the projection beam (PB) according to a desired pattern;
- a substrate table (WT) for holding a substrate (W);
- a projection system (PL) for projecting the patterned beam onto a target portion of the substrate (W); and
- a Lorentz actuator comprising a coil arrangement (1) in thermal contact with a cooling element (2), wherein:
said coil arrangement (1) comprises:
- a plurality of coils (5) separated from each other by one or more separation layers (6) of high thermal conductivity material arranged to be in good thermal contact with said cooling element (2), **characterized in that**:
at least one of said plurality of separation layers (6) is parallel to the plane of said coil arrangement (1) and all of said cooling element (2) is located radially outward from said coil arrangement (1).

2. A lithographic projection apparatus according to claim 1, wherein at least one of said separation layers (6) is perpendicular to the plane of said coil arrangement (1) and wherein said lithographic projection apparatus further comprises a cooling element (2) located axially above and/or axially below said coil arrangement (1).

3. A lithographic projection apparatus according to claim 1, wherein said separation layers (6) comprise first layers that are parallel to the plane of said coil arrangement (1) and second layers that are perpendicular to the plane of said coil arrangement (1) and wherein said cooling element (2) comprises first elements located entirely radially outward from said coil arrangement (1) and second elements located axially above or below said coil arrangement (1).

4. A lithographic projection apparatus according to any one of the preceding claims, wherein the said cooling element (2) and/or said separation layers (6) are formed of steel.

5. A lithographic projection apparatus according to any one of the preceding claims, wherein the said cooling element (2) and/or said separation layers (6) are formed of ceramic.

6. A lithographic projection apparatus according to any one of the preceding claims, wherein said cooling element (2) is a plate containing cooling channels (4), whereby a coolant fluid can be circulated through said cooling channels.

7. A lithographic projection apparatus according to claim 6, wherein said cooling channels (4) have a substantially circular or a substantially rectangular cross-section.

8. A lithographic projection apparatus according to any of the preceding claims, wherein said separation layers (6) contain cooling channels (4), whereby a coolant fluid can be circulated through said cooling channels (4).

9. A device manufacturing method comprising the steps of:
- providing a substrate (W) that is at least partially covered by a layer of radiation-sensitive material;
- providing a projection beam (PB) of radiation using a radiation system (Ex,IL);
- using patterning means (MA) to endow the projection beam (PB) with a pattern in its cross-section;
- projecting the patterned beam of radiation onto a target portion of the layer of radiation-sensitive material;
- operating a Lorentz actuator, which comprises a coil arrangement (1) in thermal contact with a cooling element (2), wherein:
said coil arrangement (1) comprises:
- a plurality of coils (5) separated from each other by one or more separation layers (6) of high thermal conductivity material arranged to be in good thermal contact with said cooling element (2), **characterized in that**:
at least one of said plurality of separation layers (6) is parallel to the plane of said coil arrangement (1) and all of said cooling element (2) is located radially outward from said coil arrangement (1).

## Patentansprüche

1. Ein lithographisches Projektionsgerät, das Folgendes beinhaltet:
- ein Strahlungssystem (Ex, IL) zum Bereitstellen eines Projektionsstrahls (PB) aus Strahlung;
- eine Stützstruktur (MT) zum Stützen eines Musteraufbringungsmittels (MA), wobei das Musteraufbringungsmittel (MA) dazu dient, den Projektionsstrahl (PB) gemäß einem gewünschten Muster zu mustern;
- einen Substrattisch (WT) zum Halten eines Substrats (W);
- ein Projektionssystem (PL) zum Projizieren des gemusterten Strahls auf einen Zielabschnitt des Substrats (W); und
- einen Lorentz-Aktuator, der eine Spulenanordnung (1) in Thermokontakt mit einem Kühlelement (2) beinhaltet, wobei:
die Spulenanordnung (1) Folgendes beinhaltet:
- eine Vielzahl von Spulen (5), die voneinander durch eine oder mehrere Trennschichten (6) aus Material mit hoher Wärmeleitfähigkeit getrennt sind, eingerichtet, um mit dem Kühlelement (2) in gutem Thermokontakt zu stehen, **dadurch gekennzeichnet, dass**:
mindestens eine der Vielzahl von Trennschichten (6) zu der Ebene der Spulenanordnung (1) parallel ist und sich das ganze Kühlelement (2) radial außerhalb der Spulenanordnung (1) befindet.

2. Lithographisches Projektionsgerät gemäß Anspruch 1, wobei mindestens eine der Trennschichten (6) zu der Ebene der Spulenanordnung (1) senkrecht ist und wobei das lithographische Projektionsgerät ferner ein Kühlelement (2) beinhaltet, das sich axial oberhalb und/oder axial unterhalb der Spulenanordnung (1) befindet.

3. Lithographisches Projektionsgerät gemäß Anspruch 1, wobei die Trennschichten (6) erste Schichten, die zu der Ebene der Spulenanordnung (1) parallel sind, und zweite Schichten, die zu der Ebene der Spulenanordnung (1) senkrecht sind, beinhalten und wobei das Kühlelement (2) erste Elemente, die sich gänzlich radial außerhalb der Spulenanordnung (1) befinden, und zweite Elemente, die sich axial oberhalb oder unterhalb der Spulenanordnung (1) befinden, beinhaltet.

4. Lithographisches Projektionsgerät gemäß einem der vorhergehenden Ansprüche, wobei das Kühlelement (2) und/oder die Trennschichten (6) aus Stahl gebildet sind.

5. Lithographisches Projektionsgerät gemäß einem der vorhergehenden Ansprüche, wobei das Kühlelement (2) und/oder die Trennschichten (6) aus Keramik gebildet sind.

6. Lithographisches Projektionsgerät gemäß einem der vorhergehenden Ansprüche, wobei das Kühlelement (2) eine Platte ist, die Kühlkanäle (4) enthält, wodurch ein Kühlmittelfluid durch die Kühlkanäle zirkuliert werden kann.

7. Lithographisches Projektionsgerät gemäß Anspruch 6, wobei die Kühlkanäle (4) einen im Wesentlichen kreisförmigen oder einen im Wesentlichen rechteckigen Querschnitt aufweisen.

8. Lithographisches Projektionsgerät gemäß einem der vorhergehenden Ansprüche, wobei die Trennschichten (6) Kühlkanäle (4) enthalten, wodurch ein Kühlmittelfluid durch die Kühlkanäle (4) zirkuliert werden kann.

9. Ein Verfahren zum Herstellen einer Vorrichtung, das die folgenden Schritte beinhaltet:
- Bereitstellen eines Substrats (W), das mindestens teilweise mit einer Schicht aus strahlungsempfindlichem Material überzogen ist;
- Bereitstellen eines Projektionsstrahls (PB) aus Strahlung unter Verwendung eines Strahlungssystems (Ex, IL);
- Verwenden eines Musteraufbringungsmittels (MA), um den Projektionsstrahl (PB) in seinem Querschnitt mit einem Muster zu versehen;
- Projizieren des gemusterten Strahls aus Strahlung auf einen Zielabschnitt der Schicht aus strahlungsempfindlichem Material;
- Betreiben eines Lorentz-Aktuators, der eine Spulenanordnung (1) in Thermokontakt mit einem Kühlelement (2) beinhaltet, wobei:
die Spulenanordnung (1) Folgendes beinhaltet:
- eine Vielzahl von Spulen (5), die voneinander durch eine oder mehrere Trennschichten (6) aus Material mit hoher Wärmeleitfähigkeit getrennt sind, eingerichtet, um mit dem Kühlelement (2) in gutem Thermokontakt zu stehen, **dadurch gekennzeichnet, dass**:
mindestens eine der Vielzahl von Trennschichten (6) zu der Ebene der Spulenanordnung (1) parallel ist und sich das ganze Kühlelement (2) radial außerhalb der Spulenanordnung (1) befindet.

## Revendications

1. Un appareil de projection lithographique comprenant :
- un système de rayonnement (Ex, IL) destiné à fournir un faisceau de projection (PB) de rayonnement ;
- une structure formant support (MT) destinée à supporter un moyen pour conformer selon un motif (MA), le moyen pour conformer selon un motif (MA) servant à conformer le faisceau de projection (PB) selon un motif souhaité ;
- une table porte-substrat (WT) destinée à porter un substrat (W) ;
- un système de projection (PL) destiné à projeter le faisceau à motif sur une portion cible du substrat (W) ; et
- un actionneur de Lorentz comprenant un arrangement de bobines (1) en contact thermique avec un élément de refroidissement (2), dans lequel :
ledit arrangement de bobines (1) comprend :
- une pluralité de bobines (5) séparées les unes des autres par une ou plusieurs couches de séparation (6) en matériau à forte conductivité thermique arrangées afin d'être en bon contact thermique avec ledit élément de refroidissement (2), **caractérisé en ce que** :
au moins une couche d'entre ladite pluralité de couches de séparation (6) est parallèle au plan dudit arrangement de bobines (1) et l'intégralité dudit élément de refroidissement (2) est situé radialement vers l'extérieur dudit arrangement de bobines (1).

2. Un appareil de projection lithographique selon la revendication 1, dans lequel au moins l'une desdites couches de séparation (6) est perpendiculaire au plan dudit arrangement de bobines (1) et dans lequel ledit appareil de projection lithographique comprend en outre un élément de refroidissement (2) situé axialement au-dessus et/ou axialement en dessous dudit arrangement de bobines (1).

3. Un appareil de projection lithographique selon la revendication 1, dans lequel lesdites couches de séparation (6) comprennent des premières couches qui sont parallèles au plan dudit arrangement de bobines (1) et des deuxièmes couches qui sont perpendiculaires au plan dudit arrangement de bobines (1) et dans lequel ledit élément de refroidissement (2) comprend des premiers éléments situés entièrement radialement vers l'extérieur dudit arrangement de bobines (1) et des deuxièmes éléments situés axialement au-dessus ou en dessous dudit arrangement de bobines (1).

4. Un appareil de projection lithographique selon l'une quelconque des revendications précédentes, dans lequel ledit élément de refroidissement (2) et/ou lesdites couches de séparation (6) sont formés en acier.

5. Un appareil de projection lithographique selon l'une quelconque des revendications précédentes, dans lequel ledit élément de refroidissement (2) et/ou lesdites couches de séparation (6) sont formés en céramique.

6. Un appareil de projection lithographique selon l'une quelconque des revendications précédentes, dans lequel ledit élément de refroidissement (2) est une plaque contenant des canaux de refroidissement (4), un fluide réfrigérant pouvant être amené à circuler dans lesdits canaux de refroidissement.

7. Un appareil de projection lithographique selon la revendication 6, dans lequel lesdits canaux de refroidissement (4) ont une coupe transversale substantiellement circulaire ou substantiellement rectangulaire.

8. Un appareil de projection lithographique selon n'importe lesquelles des revendications précédentes, dans lequel lesdites couches de séparation (6) contiennent des canaux de refroidissement (4), un fluide réfrigérant pouvant être amené à circuler dans lesdits canaux de refroidissement (4).

9. Un procédé de fabrication de dispositif comprenant les étapes consistant à :
- fournir un substrat (W) qui est au moins partiellement recouvert d'une couche de matériau sensible au rayonnement ;
- fournir un faisceau de projection (PB) de rayonnement à l'aide d'un système de rayonnement (EX, IL) ;
- utiliser un moyen pour conformer selon un motif (MA) afin de doter le faisceau de projection (PB) d'un motif dans sa coupe transversale ;
- projeter le faisceau de rayonnement à motif sur une portion cible de la couche de matériau sensible au rayonnement ;
- faire fonctionner un actionneur de Lorentz, lequel comprend un arrangement de bobines (1) en contact thermique avec un élément de refroidissement (2), dans lequel :
ledit arrangement de bobines (1) comprend :
- une pluralité de bobines (5) séparées les unes des autres par une ou plusieurs couches de séparation (6) en matériau à forte conductivité thermique arrangées afin d'être en bon contact thermique avec ledit élément de refroidissement (2), **caractérisé en ce que** :
au moins une couche d'entre ladite pluralité de couches de séparation (6) est parallèle au plan dudit arrangement de bobines (1) et l'intégralité dudit élément de refroidissement (2) est situé radialement vers l'extérieur dudit arrangement de bobines (1).
